# EUROPEAN PATENT APPLICATION

(11) **EP 4 596 749 A1**
(43) Date of publication of application: **06.08.2025**
(21) Application number: 25153777.5
(22) Date of filing: 24.01.2025
(51) Int. Cl.: C23C 16/44, C23C 16/46, C30B 25/08, C30B 25/10

(54) **REACTOR CASING ASSEMBLY**

(30) Priority: 31.01.2024 US 202463627366 P
(71) Applicant: ASM IP Holding B.V., 1322 AP Almere (NL)
(72) Inventor: AZIMI, Amin, Phoenix, Arizona (US); PARDE, Terry, Chandler, Arizona (US); RABINOVICH, Felix, Scottsdale, Arizona (US)
(74) Representative: Buzzi, Notaro & Antonielli d'Oulx S.p.A.

(57) **Abstract**

A casing assembly (10) for a reaction chamber suitable for the epitaxial deposition of a semiconductor film on a substrate comprising:

- An inner casing (100) and an outer casing (150) extending along a longitudinal direction (x); the inner casing being placed coaxially with respect to the outer casing and being at least partly contained therein; and

- a first flange (200) and a second flange (250), connecting the inner and the outer casing and defining a liquid-tight interspace;

wherein the first flange or the second flange comprises at least one inlet (300) for directing a cooling fluid in said liquid-tight interspace; and the first flange or the second flange comprises at least one outlet (350) for discharging the cooling fluid out of the liquid-tight interspace; the outer casing and/or the inner casing comprising at least one transparent quartz portion (151) and at least one opaque quartz portion (152).

A reaction chamber (500) enclosed by said casing assembly and a reactor (1000) employing said reaction chambers.

## Description

### FIELD OF INVENTION

The present invention relates to the field of epitaxial deposition of semiconductor films on substrates; in particular to a casing assembly of a reaction chamber featuring a double casing design. The present invention further relates to reaction chamber and a reactor comprising said casing assembly.

Additionally, though not exclusively, the present invention relates to the field of the deposition of silicon carbide and gallium nitride films on a semiconductor substrate in a hot-wall, crossflow, homoepitaxial or heteroepitaxial reactor.

### BACKGROUND OF THE DISCLOSURE

Semiconductor films made by epitaxial growth, also known as epilayers, are formed by deposition in the reaction chamber of a reactor. The deposited material may be the same as the substrate or involve different semiconductors with specific desirable qualities. Epitaxial techniques allow to control the crystal structure formed over the substrate and to improve the epilayer surface's features, making them suitable for the manufacturing of highly complex microprocessors and memory devices.

Typically, the reaction chamber is heated to a desired temperature before film deposition, and the temperature is then maintained substantially constant throughout the deposition process. To this effect, insulating systems are used to reduce the energy required to achieve and maintain the nominal temperature of the deposition process.

The epitaxial growth equipment for silicon (Si), silicon germanium (SiGe), silicon carbide (SiC) or gallium nitride (GaN) industry may comprise a hot-wall reaction chamber, where the walls are actively heated and temperatures may reach 1800 °C in the area where the chemical vapor deposition process occurs.

These temperatures may be achieved via an induction heating system, for example comprising an induction coil wrapped around the reaction chamber and connected to a power generation circuit. In this case, the chamber may comprise one or more thermally conductive elements, such as an assembly of one or more graphite pieces. Indeed, graphite features high susceptivity and will heat up effectively under an alternating electromagnetic field.

The chamber above described typically comprises an enclosure which may perform one or more of the following functions: (i) protect the chamber from contamination, (ii) provide an enclosure for vacuum generation, (iii) prevent overheating of the chamber's surrounding environment, and (iv) prevent leakage of process gases within the reactor.

The above enclosure must avoid interacting and interfering with the electromagnetic field generated by the induction heating system and should be able to satisfactorily withstand temperatures of up to 1000°C without suffering structural damage, and without releasing contaminants within the chamber.

In order to provide an enclosure with the above features, a quartz tube such as the one described in US20230313410 is often used. The tube may be hollow and cooled with an internal liquid flow. The cooling of the tube will allow the quartz to better withstand the heat radiating from the reaction chamber.

The quartz enclosure is typically manufactured by welding together two concentric quartz tubes, joining them at the edges. This allows to create a liquid-tight interspace between the tubes for flowing and discharging a cooling fluid, such as water, through a series of inlets and outlets extruded on the surface of the external tube.

The above solution, however, is not ideal: the welding of the concentric quartz tubes often results in the tubes being irreparably damaged, thereby impacting production costs. Overall, the welding process is mostly artisanal in nature with unpredictable yield, which substantially increases the manufacturing costs of the quartz enclosure and creates serious procurement issues.

### SUMMARY OF THE DISCLOSURE

It is an object of the present invention to overcome the disadvantages of the prior art. More specifically, it is an object of the present invention to provide a casing assembly for a reaction chamber comprising: (i) a quartz inner casing and a quartz outer casing extending along a longitudinal direction (x), the inner casing being placed coaxially with respect to the outer casing and being at least partly contained therein; (ii) a first flange and a second flange connecting the inner and the outer casing and creating a liquid-tight interspace between them. Said first flange comprises at least one inlet for directing a cooling fluid in said liquid-tight interspace; and either the first or the second flange comprises at least one outlet for discharging the cooling fluid out of the liquid-tight interspace. Either the quartz inner casing or the quartz outer casing, or both, comprise one opaque and one transparent quartz portions

It is a further object of the present invention to provide a reaction chamber for the epitaxial film deposition equipped with the casing assembly above described, and a reactor incorporating said reaction chamber.

The main objectives hereinbefore described are achieved through the invention recited in the appended claims, which constitute an integral part of the present description.

It is noted that the use of reference signs in the claims does not limit their scope. The sole purpose of reference signs is to make the claims easier to understand.

This summary is provided to introduce a selection of concepts in a simplified form. These concepts are further described in the detailed description of example embodiments of the disclosure below. This summary is not intended to identify key features or essential features of the claimed subject matter, nor is it intended to be used to limit the scope of the claimed subject matter.

### BRIEF DESCRIPTION OF THE DRAWING FIGURES

Fig. 1 provides a simplified sketch of a first embodiment of the casing assembly according to the invention. Panel a) provides a view from the side of the casing assembly along a longitudinal direction (x), whereas panel b) provides a frontal view in a plane (yz) perpendicular thereto.
Fig. 2 provides a side view of a second embodiment of the casing assembly according to the invention.
Fig. 3 schematically illustrates parts of a reaction chamber according to another aspect of the invention. Panel a) provides a view from the lateral side along a longitudinal direction (x), whereas panel b) provides a frontal view in a plane (yz) perpendicular thereto.

It will be appreciated that elements in the figures are illustrated for simplicity and clarity and have not necessarily been drawn to scale. For example, the dimensions of some of the elements in the figures may be omitted or exaggerated relative to other elements to help improve understanding of illustrated embodiments of the present disclosure.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

According to a first aspect, the present invention relates to a casing assembly for a reaction chamber suitable for the epitaxial deposition of a semiconductor film on a substrate, including, but not limited to, the deposition of Si, SiGe, SiC or GaN films on semiconductor substrates of same or different material in a horizontal, hot wall, single wafer reaction chamber.

The casing assembly according to the invention comprises an inner casing and an outer casing made of quartz and extending along a longitudinal direction (x) in the horizontal plane. The inner casing is placed coaxially with respect to the outer casing and is partly or completely contained within the latter.

The inner and outer casings are hollow and may have an essentially prismatic or cylindrical shape, preferably with a circular, oval, elliptical or rectangular cross section in a transverse plane (yz), here defined as any plane perpendicular to the longitudinal direction (x).

The lengths of the inner and outer casings in the longitudinal direction may differ. For instance, the inner casing may extend beyond the edges of the outer casing.

The outer casing and/or the inner casing comprise at least one transparent quartz portion and at least one opaque quartz portion. This allows to manufacture and procure an outer and/or inner casing with variable cross section more easily, and to better adapt the outer and/or inner casing to the shape of the first and/or second flange.

The casing assembly provides an enclosure for the reaction chamber. In this enclosure it is possible to place, access, and move the reaction and deposition unit of the reaction chamber (and parts thereof). The reaction and deposition unit is the core of the reactor where the semiconductor substrates are placed, typically on a substrate holder, for the actual epitaxial deposition process to take place.

The sides of the inner and outer casings are open in the transverse plane, and may be closed, or partially closed as described hereinafter. These sides are also referred to as upstream and downstream sides respectively depending on the direction of the injection/discharge of precursor gases in the reaction and deposition unit.

The inner and outer casings are connected to a first flange at one side, and a to a second flange at the opposite side. These flanges create a closed and liquid-tight interspace between the internal surface of the outer casing and the external surface of the inner casing. This liquid-tight interspace is suitable for flowing a cooling fluid, such as demineralized water, to keep the quartz elements from overheating. The cooling fluid may be under a slight pressure, creating a differential pressure with respect to its surroundings in the order of 0.3-1 bar. To counteract this pressure, a plurality of pushers and/or spacers located on the external surface of the flanges can prevent them from outwards displacement.

The first flange comprises at least one inlet for directing a cooling fluid into the liquid-tight interspace; and either the first or the second flange comprises at least one outlet for discharging the cooling fluid out of the liquid-tight interspace.

It is understood that with the expression "liquid-tight interspace" it is meant a cavity where the cooling fluid may flow without leaking into its surroundings. The cavity is enclosed by the inner and outer casings and the first and second flanges. The cavity may communicate, through one or more of its inlets, to a piping system and/or a container providing a cooling fluid, optionally under pressure. The cavity may also communicate, through one or more of its outlets, to a piping system and/or container and/or drain that allows to discharge the cooling fluid after use. The cooling fluid may also follow a closed loop that allows for a continuous circulation of the liquid in and out of the cavity.

The number of inlets and outlets may be each kept below 20, to simplify the manufacturing of the piece and/or for space constraints.

The first flange may be indifferently located on the upstream or downstream side of the reaction chamber (with the second flange conversely located downstream or upstream), depending on the reactor's structural features.

The use of flanges avoids the problems of welding of the inner and outer quartz casings together, thereby ensuring a quicker, more efficient, and cost-effective manufacturing process. The physical characteristics of the flanges will depend on the size of the casing assembly, the weight of its parts, and the differential pressure induced by the cooling liquid that the assembly is subject to when compared to its surrounding environment.

According to another embodiment, the casing assembly of the present invention further comprises one or more pipes positioned within the liquid-tight interspace and extending along the longitudinal direction, in a straight or winding, serpentine line. Advantageously, the number of pipes may be kept below 20 and chosen to be in the same number of the inlets.

In the present embodiment, each pipe is connected to an inlet and is provided with at least one aperture for injecting a cooling fluid in the liquid-tight interspace. The pipe allows to better distribute the cooling fluid within the liquid-tight interspace. This is especially true if the inlets and outlets are placed on the same flange: the pipes force the cooling fluid to flow over larger surfaces of the inner and outer casing by bringing the cooling fluid further from the outlets in the longitudinal direction. The number and spacing of the inlets and outlets in the transverse plane also affect the distribution of cooling fluid, as a person with average skill in the art may infer.

Advantageously, the pipes may be provided with a plurality of apertures placed at different positions along the longitudinal direction for improving the spatial distribution of cooling fluid and hence ensure a particularly uniform and effective cooling of the casing assembly. The apertures may be of same or different size and shape.

In general, the cooling of the casing assembly ensures better mechanical stability of the quartz elements and is especially crucial for hot walls reactors such as those hereinbefore described for Si, SiGe, SiC, or GaN epitaxial deposition, and especially for SiC, or GaN deposition. In the latter instances, for example, the casing assembly may be exposed to temperatures up to 1000°C, as the neighboring reaction and deposition unit is brought to extremely high temperatures (1000-1800 °C), and consequently irradiates heat to the casing assembly.

According to another embodiment, the casing assembly of the present invention further comprises: (i) a first O-ring and a second O-ring respectively coupling the first flange and the second flange with the inner casing; and (ii) a third O-ring and a fourth O-ring respectively coupling the first flange and the second flange with the outer casing.

These four O-rings are essential to prevent leakages of the cooling fluid from the liquid-tight interspace. The first and second flange will feature appropriate indentations to lodge the four O-rings.

When pipe(s) connected to the inlet(s) are used, the O-ring sealing the outer casing is subject to different constraints depending on whether it is placed on: (i) the flange with the inlets, or (ii) the flange without inlets.

In the first case, the pipes, or any connecting conduits thereto, will pass through the flange under the O-ring. Hence the O-ring will be always positioned outwards with respect to the pipe or any conduit connecting the pipe and the inlet.

In the second case, the O-ring may be positioned behind the extremity of the tube, to save space. Therefore, it is possible that the third and fourth O-rings have a different diameter, as well as the portion of the flanges in correspondence of the two O-rings. For the two O-rings to properly seal the outer casing, in this instance, the outer casing should exhibit a variable cross section.

The configuration hereinbefore described may be advantageously achieved by keeping an essentially constant cross section of the outer casing throughout its length and to locally alter its cross section in correspondence of the flange with the inlets, by creating an alteration, or "step".

There are many ways in which this local alteration in the cross section may be achieved. In order to take advantage of standard commercially available cylindrical or parallelepiped quartz duct casings, it is possible to manufacture/procure the alteration and the standard structure separately and to subsequently join them together in a permanent fashion.

To avoid damaging these quartz parts when combining them, the inventors have found that diffusion welding techniques work particularly well in the execution of the invention.

The inventors also observed that the quartz used for the standard duct casing and for the added custom piece may differ. Specifically, the former may be transparent, and the latter opaque, to facilitate procurement of parts. The difference in optical properties of the two parts does not affect the overall performance and functionality of the outer casing. It is noted, however, that if the entirety of the inner and/or outer casing were made of opaque quartz, they would likely overheat because of increased heat absorption properties of the material.

The inventors have found that a casing assembly of essentially cylindrical shape works well in the execution of the invention: thanks to its symmetry, the assembly of parts is facilitated.

By essentially cylindrical shape it is meant a shape which may locally deviate from an ideal cylinder shape for not more than 15% of its length.

The person of average skill in the art will appreciate that, case by case, the casing assembly will require additional elements to properly perform according to its purposes. For example, at least a third and fourth flanges may be used to couple the casing assembly, and more specifically the inner casing, with other elements/areas up- and down-stream of the reaction chamber. Advantageously, these flanges may be made of stainless steel.

The casing assembly may also include additional O-rings, for example to seal (a) the inlets on the first (or second) flange, and, if present, (b) the pipes to the inlets.

Under a second aspect, the present invention relates to a reaction chamber for the epitaxial deposition of a semiconductor film on a substrate comprising the casing assembly according to any one of the embodiments hereinbefore described.

The reaction chamber also comprises a reaction and deposition unit, where the actual film deposition takes place, extending along the longitudinal direction and comprising one or more structural/partition elements made of a susceptive material, i.e. a material with high susceptivity such as graphite, which may heat up effectively under an electromagnetic field.

The reaction and deposition unit is provided with a receiving area adapted to receive a substrate holder, and may be further equipped with means for rotating, measuring, and controlling the angular velocity of the substrate holder. The reaction and deposition unit may be optionally specifically designed for a horizontal, hot-wall reactor for Si or SiGe, and preferably SiC or GaN deposition. It may comprise elements made of SiC, and/or parts coated with SiC or TaC.

The reaction chamber further comprises a thermal insulation system encasing the reaction and deposition unit and adapted to minimize heat dispersion from the same. The thermal insulation system may be made of porous carbonaceous materials, for instance carbon composites made from short cut carbon fibers, optionally interconnected in a matrix or pressed together. The thermal insulation system may be composed of one or more thermally insulating shells.

The thermal insulation system may further comprise thermally insulating caps to close the upstream and downstream sides of the reaction and deposition unit. These caps may be provided with inlets and outlets to allow the introduction and discharge of precursors and other operation gases.

The casing assembly defines the perimeter of the reaction chamber, and it encloses both the reaction and deposition unit and the thermal insulation system.

The casing assembly may also include connections to a vacuum generation system, as the chamber may be brought to a pressure as low as 10⁻⁷ mbar.

The casing assembly, the reaction and deposition unit, and the insulating system may all exhibit an essentially cylindrical shape.

Under a third aspect, the present invention relates to a reactor for the epitaxial deposition of a semiconductor film on a substrate.

The reactor comprises: (i) at least one reaction chamber hereinbefore described, and (ii) an inductive heating system adapted to heat the susceptive elements of the reaction and deposition unit of the at least one reaction chamber.

The reactor according to the invention may be advantageously chosen for the homo- or hetero-epitaxial deposition of Si or SiGe, and preferably of SiC or GaN, and may be chosen to be of the horizonal, single wafer, hot wall type.

It is understood that the reactor according to the invention will include many other elements which are generally required for its operation.

For instance, the reactor will include a gas panel for controlling the delivery of process and operation gases trough an appropriate assembly of gas pipes and gas liners. The process and operation gases include precursor and cooling gases for the reaction chamber, as well as gases for the rotation of the substrate holder and/or for flushing the chamber to remove residues after use.

The reactor will generally comprise a system for the discharge of the exhausted gases and for controlling the rotation speed of the substrate holder. The reactor will typically also include a system for vacuum generation and a water line and a demineralized water tank for cooling the casing assembly.

The illustrations presented hereinafter are not meant to be actual views of any particular material, structure, or device, but are merely idealized representations that are used to describe embodiments of the disclosure. Specifically, they are not intended to otherwise limit the scope of the aspects and implementations in any way. Indeed, for the sake of brevity, conventional manufacturing, connection, preparation, and other functional aspects of the system may not be described in detail. Furthermore, the connecting lines shown in the various figures are intended to represent exemplary functional relationships and/or physical couplings between the various elements. Many alternative or additional functional relationship or physical connections may be present in the practical system, and/or may be absent in some embodiments.

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

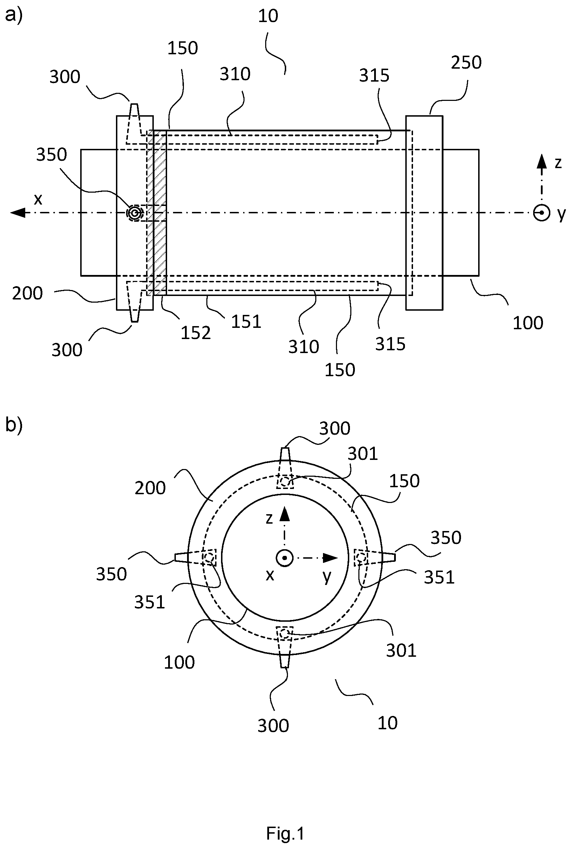

Fig. 1 shows a simplified sketch of an embodiment of the casing assembly (10) according to the invention. It provides a) a lateral view along the longitudinal direction (x), and b) a frontal view in the plane (yz) orthogonal to (x).

Specifically, panel a) shows a casing assembly (10) comprising an inner casing (100) and an outer casing (150) made of quartz and connected via a first flange (100) and a second flange (200). The outer casing comprises a transparent (151) and opaque (152) quartz portions.

In this example the sides of the outer casing abut on the first and second flange, whereas the inner casing is longer and extends beyond them. Both the inner and outer casing are hollow and have an essentially cylindrical shape. The first flange is provided with two inlets (300) for the injection of a cooling fluid, such as demineralized water, in the liquid-tight interspace.

Each inlet is connected to a pipe (310) with an open end, i.e. an aperture (315) at its extremity. The aperture is placed in close proximity to the second flange. The cooling fluid therefore spreads out in correspondence of the second flange and flows back towards the first flange, where two outlets (350) are located (only one of which is visible in this view).

The inlets and the pipes may be connected via a short conduit in the longitudinal direction manufactured within the flange. The pipe may partly rest within this conduit.

Panel b) shows the same casing assembly (10) of panel a) as seen from the front, in the transverse plane (yz). This view showcases the circular cross section of both the inner and outer casing (100, 150), and of the first flange (200). The inlets (300) and outlets (350) are located on the first flange. The conduits (301, 351) respectively connect the inlets with the pipes (not shown) and the outlet to the liquid-tight interspace, so that the cooling liquid may be discharged after use. The conduits are short channels in the longitudinal direction and manufactured within the flange. They connect the inlet with the pipe, the latter being optionally partially inserted within said conduit, for its entire length or a section thereof.

In general, when the inlets and outlets are located on one same flange, it is convenient to alternate them radially. In both panel a) and b) the thickness of the inner and outer casing, pipes, and inlets and outlets are not shown.

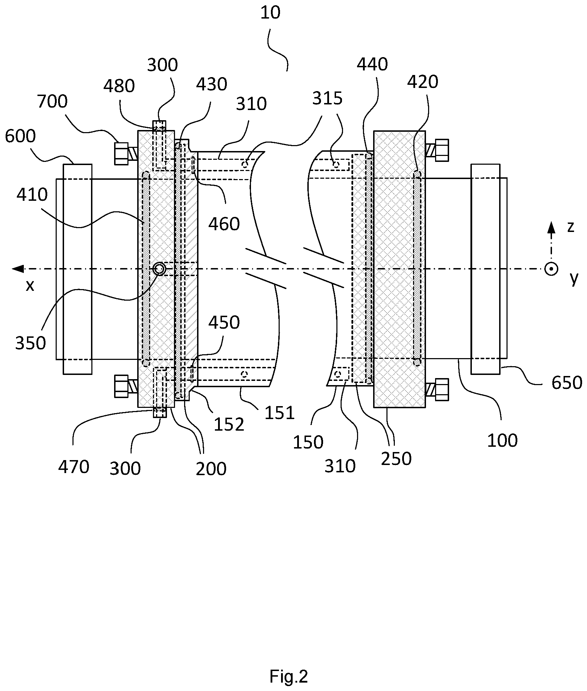

Fig. 2 provides a simplified lateral view of an embodiment of the casing assembly (10) of the present invention, along the longitudinal direction (x), orthogonal to the transverse plane (yz). The first and second flanges (200, 250) connect the inner and outer casing (100, 150), which are two quartz tubes of different length.

The flanges and the tubes define a liquid-tight interspace between them. Two inlets (300) and two outlets (350, only one is shown) are located on the first flange. In general, the person with average skill in the art will adapt the number of connections with the size of the assembly and the temperatures reached during operation.

The inlets are adapted to inject cooling fluid in the liquid-tight interspace. The fluid may spread out and reach the outlets on the other side of the outer casing for discharge.

To better achieve this goal, in the present embodiment each inlet is connected to a pipe (310) provided with apertures (315) spaced along the longitudinal direction (x).

At least two stainless steel flanges (600, 650) are located at the sides of the inner casing (100). The stainless-steel flanges may have a ring-like shape. They are used to couple the casing assembly with other elements located up- and down-stream with respect to the reaction chamber, such as enclosed areas, or drums, used to isolate the chamber or to perform specific operations.

A plurality of pushers (700) is used to counteract the pressure exerted on the first and second flange by the cooling fluid within the interspace.

At least four O-rings (410, 420, 430, 440) are used. A first O-ring (410) and a second O-ring (420) respectively couple the first flange and the second flange with the inner casing. They are positioned within appropriate grooves or indentations manufactured within the flange.

A third O-ring (430) and a fourth O-ring (440) respectively couple the first flange and the second flange with the outer casing. They are both positioned within appropriate grooves or indentations manufactured in the flange.

It is noted that both the first and the second flange feature a variable cross section in the transverse plane, here represented with a "step" on both flanges, and hosting respectively the seats for the third and fourth O-rings.

The lateral shape of the flanges is highlighted for clarity by using a crisscross pattern, and allows to recognize how the "step" brings part of the first and second flange under the outer casing on both sides thereof.

The outer casing comprises a transparent quartz portion (151) of standard cylindrical shape, and an opaque quartz portion (152) which partly envelops the first flange by also making a slight step, which locally increases the cross section of the outer casing. The opaque quartz portion is highlighted with a slanted line pattern. It can be tailor made to precisely wrap around the abutting portion of the first flange, and it can be easily welded on the standard transparent tube. To avoid breakage of the parts, it may be advantageous to use diffusion welding techniques.

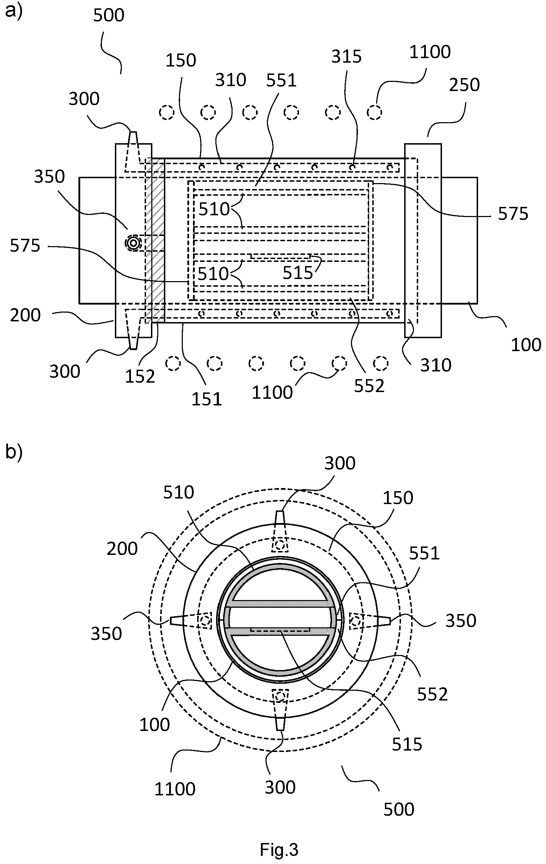

Fig. 3 schematically illustrates a reaction chamber (500) according to an embodiment of the invention. Panel a) provides a lateral view along the longitudinal direction (x), while panel b) provides a simplified view in the transverse plane (yz), using the same frame of reference of Fig. 1.

The reaction chamber comprises a casing assembly, enclosing a reaction and deposition unit (510) equipped with a receiving area (515) for a substrate holder. In panel b), the reaction and deposition unit is highlighted in grey for clarity. It comprises graphite and SiC elements. The former exhibit a half-moon shape, and are suitable to be heated via induction means for the deposition of SiC.

The reaction and deposition unit depicted herein is wrapped by a thermal insulation system. The latter comprises at least two thermally insulating shells (551, 552). Panel a) shows two additional thermally insulating caps (575), which are not included in panel b) for clarity.

The reaction and deposition unit and the thermal insulation system are enclosed by the casing assembly according to an embodiment of the invention.

The casing assembly comprises an inner casing (100), an outer casing (150), a first and second flange (200, 250), a plurality of inlets (300), and a plurality of outlets (350). The outer casing comprises a transparent (151) and an opaque (152) quartz portion, joined together by a diffusion welding technique.

Each inlet is coupled to a pipe (310) provided with a plurality of apertures (315) and abutting inside the second flange.

The inductive heating system comprises a coil (1100) wrapped around the casing and connected to a power generator. The coil is schematically shown in dotted line as it is not part of the reaction chamber. The coil is adapted to heat the reaction and deposition unit to temperatures up to 1800°C.

It is to be understood that the configurations and/or approaches described herein are exemplary in nature, and that these specific embodiments or examples are not to be considered in a limiting sense, because numerous variations are possible. The specific routines or methods described herein may represent one or more of any number of processing strategies. Thus, the various acts illustrated may be performed in the sequence illustrated, in other sequences, or omitted in some cases.

In this application the words "comprise" and its variations such as "comprising" and "comprises" do not rule out the presence of other additional elements, components, or stages, both when used in the description and in the claims.

The subject matter of the present disclosure includes all novel and nonobvious combinations and subcombinations of the various processes, systems, and configurations, and other features, functions, acts, and/or properties disclosed herein, as well as any and all equivalents thereof.

## Claims

1. A casing assembly (10) for a reaction chamber suitable for the epitaxial deposition of a semiconductor film on a substrate comprising:
- An inner casing (100) and an outer casing (150) made of quartz and extending along a longitudinal direction (x); the inner casing being placed coaxially with respect to the outer casing and being at least partly contained therein; and
- a first flange (200) and a second flange (250), connecting the inner and the outer casing and defining a liquid-tight interspace;
wherein the first flange or the second flange comprises at least one inlet (300) for directing a cooling fluid in said liquid-tight interspace; and the first flange or the second flange comprises at least one outlet (350) for discharging the cooling fluid out of the liquid-tight interspace; the outer casing and/or the inner casing comprising at least one transparent quartz portion (151) and at least one opaque quartz portion (152).

2. The casing assembly according to claim 1, further comprising one or more pipes (310) positioned within the liquid-tight interspace and extending along the longitudinal direction; wherein each of said one or more pipes is connected to an inlet and is provided with at least one aperture (315).

3. The casing assembly according to claim 2, wherein each of the one or more pipes is provided with a plurality of apertures placed at different positions along the longitudinal direction.

4. The casing assembly according to any one of claims 1-3, further comprising four O-rings:
- a first O-ring (410) and a second O-ring (420) respectively coupling the first flange and the second flange with the inner casing;
- a third O-ring (430) and a fourth O-ring (440) respectively coupling the first flange and the second flange with the outer casing.

5. The casing assembly according to claim 4, wherein the at least one opaque quartz portion is placed in correspondence of the third O-ring or the fourth O-ring.

6. The casing assembly according to any one of the preceding claims, wherein the transparent and opaque quartz portions are joined together by diffusion welding.

7. The casing assembly according to any of the preceding claims wherein the inner casing and outer casing have an essentially cylindrical shape.

8. A reaction chamber (500) for the epitaxial deposition of a semiconductor film on a substrate, comprising:
- a reaction and deposition unit (510) extending along the longitudinal direction (x) and comprising one or more structural elements made of susceptive material, the reaction and deposition unit being provided with a receiving area (515) adapted to receive a substrate holder;
- a thermal insulation system comprising one or more thermally insulating shells (551, 552) encasing the reaction and deposition unit;
- the casing assembly (10) according to any one of the preceding claims, enclosing the reaction and deposition unit and the thermal insulation system.

9. A reactor (1000) for the epitaxial deposition of a semiconductor film on a substrate, comprising:
- at least one reaction chamber (500) according to claim 8;
- at least one inductive heating system (1100) adapted to heat the susceptive elements of the reaction and deposition unit (510) of the at least one reaction chamber.
